# EUROPEAN PATENT APPLICATION

(11) **EP 4 811 429 A1**
(43) Date of publication of application: **23.09.2026**
(21) Application number: 25315091.6
(22) Date of filing: 21.03.2025
(51) Int. Cl.: H01L 23/367, H01L 23/473

(54) **LIQUID COOLING HEATSINK FOR COOLING AN ELECTRONIC CHIP**

(71) Applicant: BULL SAS, 78340 Les Clayes-Sous-Bois (FR)
(72) Inventor: Bangera, Jithendra, 560076 Bangalore - Karnataka (IN); Guggari, Shrishail, 560062 Bengaluru South - Karnataka State (IN)
(74) Representative: Argyma

(57) **Abstract**

The invention relates to a liquid cooling heatsink (1) for cooling a microprocessor (3) mounted on a printed circuit board (4) of a computing device (2), said liquid cooling heatsink (1) comprising a body (10) and a thermal interface pad (20), said body (10) comprising a heat face (10-1), a mounting face (10-2), a parallelepipedal internal cavity delimited inside the body (10), a cooling liquid inlet (120), a cooling liquid channel, a heated liquid channel, a heated liquid outlet and a plurality of parallel fins mounted in the parallelepipedal internal cavity orthogonally to said thermal interface pad and along a direction extending between a first lateral face and a second lateral face of the parallelepipedal internal cavity to allow the cooling liquid to flow between said fins.

## Description

### [Field of the invention]

The invention relates to the field of electronic component cooling and, more particularly, to a liquid cooling heatsink for cooling an electronic chip mounted on a printed circuit board of a computing device.

### [Background of the invention]

In the art of computing, in particular in high-performance computing (HPC), it is known to use a cooling heatsink to cool the electronic processor of a computing device. The heatsink is in contact with the processor to collect and evacuate the heat generated by the processor.

An air cooling heatsink is usually large in size and consumes a lot of internal space of the computing device. An air cooling heatsink may require high air flow fans to dissipate the heat, in particular a plurality of fans, which implies high-power consumption and may significantly increase its cost. The design of an air cooling heatsink may prove to be complex, which may increase their fabrication time and cost, and its dimensions are too important for some applications or some of processor components to be cooled.

For example, an electronic device of the ASIC-type mounted on a PCB may dissipate close to 750W of heat while the size of ASIC die is relatively small (24.7mm x 31.0mm), resulting in a very high heat flux, around 100W/cm². Under such heat flux level, controlling the ASIC device temperature and keeping it under the allowable max operating limit may prove to be really challenging.

A liquid cooling heatsink comprises a body which includes an internal cooling circuit where the cooling liquid flows. The internal cooling circuit is usually in the shape of a coiled tubing. However, this type of heatsink may be less efficient than an air cooling heatsink and may be not adapted to cool a processor, particularly of a high-performance computing.

It is therefore an object of the present invention to provide a device and method to remedy at least partly these drawbacks.

### [Summary of the invention]

The drawbacks of the prior art call for an innovative design of liquid cooled heatsink, high density fin fabrication challenges over small footprint. Also, the need of having a high performance and reliable choice of thermal interface material.

To this end, the present invention concerns a liquid cooling heatsink for cooling a microprocessor mounted on a printed circuit board of a computing device, said liquid cooling heatsink comprising a body and a thermal interface pad, said body comprising:
- a heat face,
- a mounting face, opposite said heat face,
- a parallelepipedal internal cavity delimited inside the body between the heat face and the mounting face, the thermal interface pad being mounted on the heat face under said internal cavity and being configured to contact said microprocessor to collect the heat generated by said microprocessor and transfer said collected heat through the body up to the internal cavity,
- a cooling liquid inlet configured to receive a cooling liquid,
- a cooling liquid channel connecting said cooling liquid inlet and said internal cavity and comprising a cooling liquid injector having an end portion leading into the internal cavity on the width of a first lateral face of said parallelepipedal internal cavity,
- a heated liquid channel connected to said internal cavity and comprising at one end a cooling liquid collector having an end portion spreading on the width of a second lateral face of the parallelepipedal internal cavity, opposite to the first lateral face, and configured to evacuate the heated liquid,
- a heated liquid outlet connected to the other end of the cooling liquid collector,
   the body further comprising a plurality of parallel fins mounted in the parallelepipedal internal cavity orthogonally to said thermal interface pad and along a direction extending between the first lateral face and the second lateral face of the parallelepipedal internal cavity to allow the cooling liquid to flow between said fins.

The liquid cooling heatsink according to the invention allows to efficiently collect and evacuate the heat generated by the microprocessor as the thermal interface pad collecting the heat spread over and contact the surface of the processor while being compact.

Advantageously, the thickness of the thermal interface pad is smaller than 1 mm, preferably equal or smaller than 0.2 mm.

In an embodiment, the height of the parallelepipedal internal cavity is smaller than 3 mm, preferably equal or smaller than 2.9 mm.

Advantageously, the width of each fin is equal or smaller than 0.2 mm.

Preferably, the gap between two adjacent fins is equal or smaller than 0.2 mm.

Advantageously, the number of fins is equal to or greater than fifty, preferably eighty, preferably equal to eighty-eight.

Preferably the body is made of aluminum 6063.

Advantageously, the thermal interface pad is a phase change thermal paste or thermal grease.

Advantageously, the thermal interface pad is a highly thermally conductive phase change material in pad or paste which has good thermal conductivity, preferably greater than 4W/m.K.

Advantageously, the thermal interface pad can fill the air gap.

Advantageously, the thermal interface pad is compressible under heatsink mounting pressure of 30 to 40 psi.

In an embodiment, the thermal interface pad has a thermal impedance of 0.08 to 0.10 (°C cm²/w) when loaded with mounting pressure close to 40 psi (+ or - 10%).

Advantageously, the liquid cooling heatsink comprises fixation organs configured to fix the body inside the computing device.

In an embodiment, the fixation organs comprise screws.

In an embodiment, the fixation organs comprise springs.

In an embodiment, the fixation organs comprise circlips.

In an embodiment, the cooling liquid inlet and the heated liquid outlet are arranged side-by-side.

The invention also relates to a computing device comprising a printed circuit board and a liquid cooling heatsink as described here before, said printed circuit board comprising a microprocessor, wherein the thermal interface pad of the liquid cooling heatsink contacts the microprocessor.

The invention also relates to a method for cooling a microprocessor using a liquid cooling heatsink as described here before, mounted on said microprocessor, said method comprising the steps of circulating a cooling liquid through the liquid cooling inlet and the liquid cooling channel, transferring the heat generated by the microprocessor through the thermal interface pad and the plurality of fins, collecting the transferred heat by the cooling liquid flowing between the fins of the plurality of fins to produce a heated liquid, evacuating said heated liquid through the heated liquid channel and the heated liquid outlet.

### [Brief description of the drawings]

These and other features, aspects, and advantages of the present invention are better understood with regard to the following Detailed Description of the Preferred Embodiments, appended Claims, and accompanying Figures, where:
Figure 1 schematically illustrates a side view in transparence of an embodiment of computing device according to the invention.
Figure 2 is a perspective top view of the liquid cooling heatsink of figure 1.
Figure 3 is a perspective bottom view of the liquid cooling heatsink of figure 1.
Figure 4 is a plane cut view of the liquid cooling heatsink of figure 2.
Figure 5 is another plane cut view of the liquid cooling heatsink of figure 2.
Figure 6 is a perspective zoomed view of the fins arrangement of the liquid cooling heatsink of figure 2.
Figure 7 is a longitudinal cut view of the liquid cooling heatsink of figure 2.
Figure 8 is a top zoomed view of the fins arrangement of the liquid cooling heatsink of figure 7.
Figure 9 is a bottom zoomed view of the fins arrangement of the liquid cooling heatsink of figure 7.
Figure 10 is a top partial view of the liquid cooling heatsink of figure 7 with a first zoomed view of the plurality of parallel fins and a second zoomed view of a few parallel fins.
Figure 11 illustrates an embodiment of the method according to the invention.

### [Detailed description]

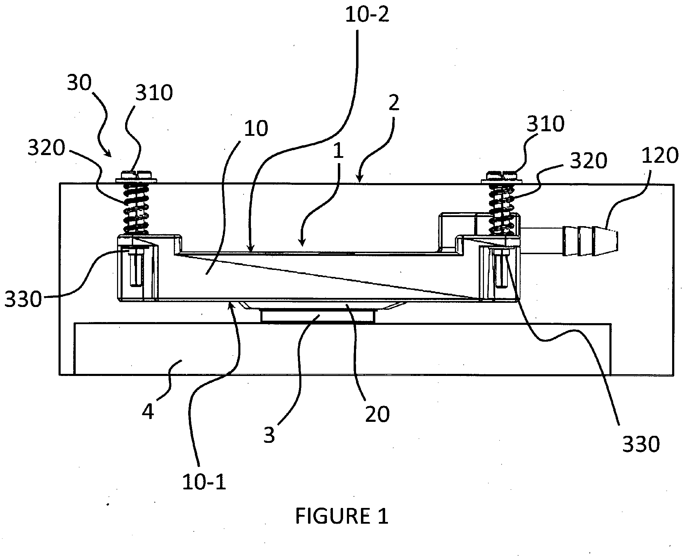

Figure 1 illustrates an example of a liquid cooling heatsink 1 according to the invention. The liquid cooling heatsink 1 is intended to be mounted into a computing device 2 (e.g., a computer or calculator) to cool a microprocessor 3 mounted on a printed circuit board 4 of said computing device 2.

The liquid cooling heatsink 1 comprises a body 10 and a thermal interface pad 20.

The body 10 is made of metal, preferably aluminum 6063.

The body 10 comprises a heat face 10-1 and a mounting face 10-2, opposite said heat face 10-1.

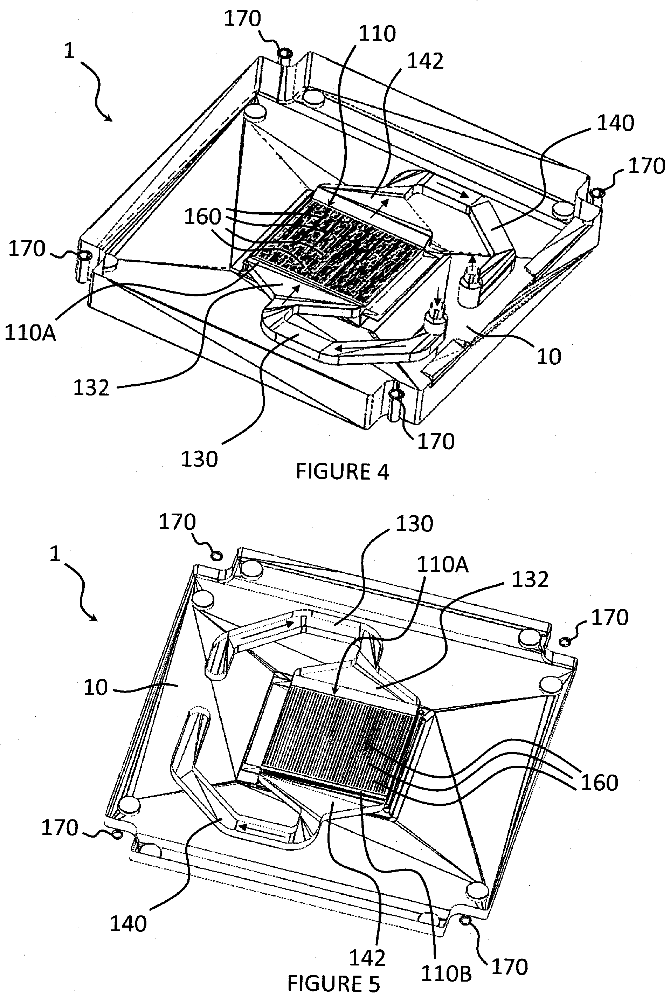

The body 10 delimitates between the heat face 10-1 and the mounting face 10-2 a parallelepipedal internal cavity 110, as shown on Figures 4, 7, 8, 9.

The parallelepipedal internal cavity 110 comprises four lateral faces. Preferably, the height of the parallelepipedal internal cavity 110 is smaller than 3 mm, still preferably equal or smaller than 2.9 mm.

The thermal interface pad 20 is mounted on the external side of the heat face 10-1, under the internal cavity 110, and is configured to contact the microprocessor 3 to collect its heat and transfer it through the body 10 up to the internal cavity 110. The thickness of the thermal interface pad 20 is smaller than 1.0 mm, preferably equal or smaller than 0.2 mm.

For example, the thermal interface pad 20 may be a phase change thermal pad, a phase change thermal paste or thermal grease.

Preferably, the thermal interface pad 20 has a thermal impedance of 0.08 to 0.10 (°C cm²/w) with mounting pressure close to 40 psi (+ or - 10%).

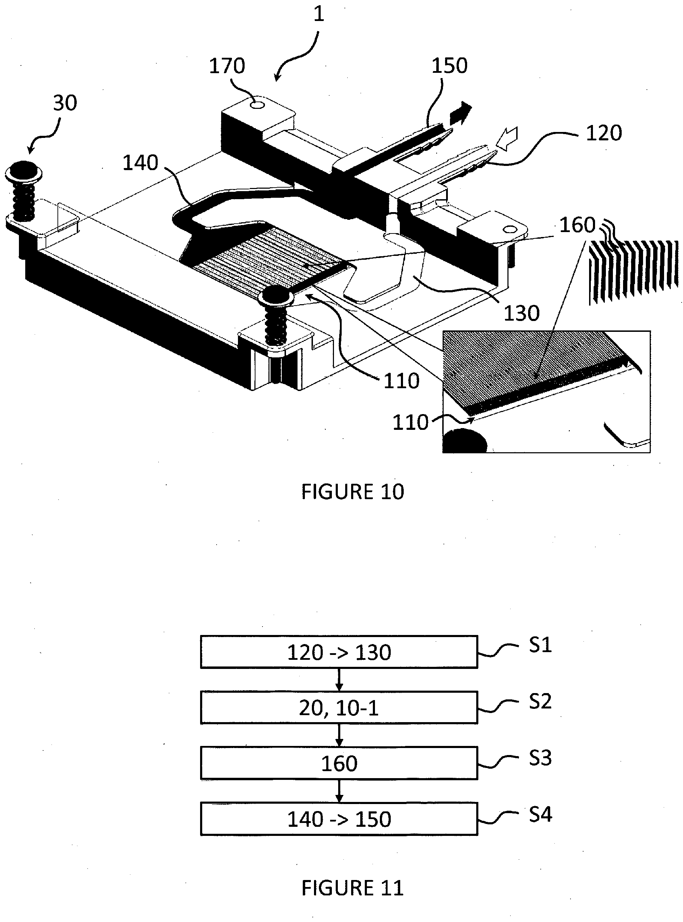

As shown for example on Figure 10, the body 10 comprises a cooling liquid inlet 120, a cooling liquid channel 130, a heated liquid channel 140, a heated liquid outlet 150 and a plurality of fins 160 mounted in the internal cavity 110.

The cooling liquid inlet 120 is configured to receive a cooling liquid, which may be any cooling liquid known from the skilled person.

The cooling liquid channel 130 connects the cooling liquid inlet 120 to the internal cavity 110 to bring the cooling liquid up to said internal cavity 110 and the fins 160 to collect heat.

As illustrated on Figures 4 to 9, the cooling liquid channel 130 comprises a cooling liquid injector 132 that leads into the internal cavity 110 on the width of a first lateral face 110A of said parallelepipedal internal cavity 110 to allow the cooling liquid to flow between all the fins 160 at the same time and collect a maximum of heat.

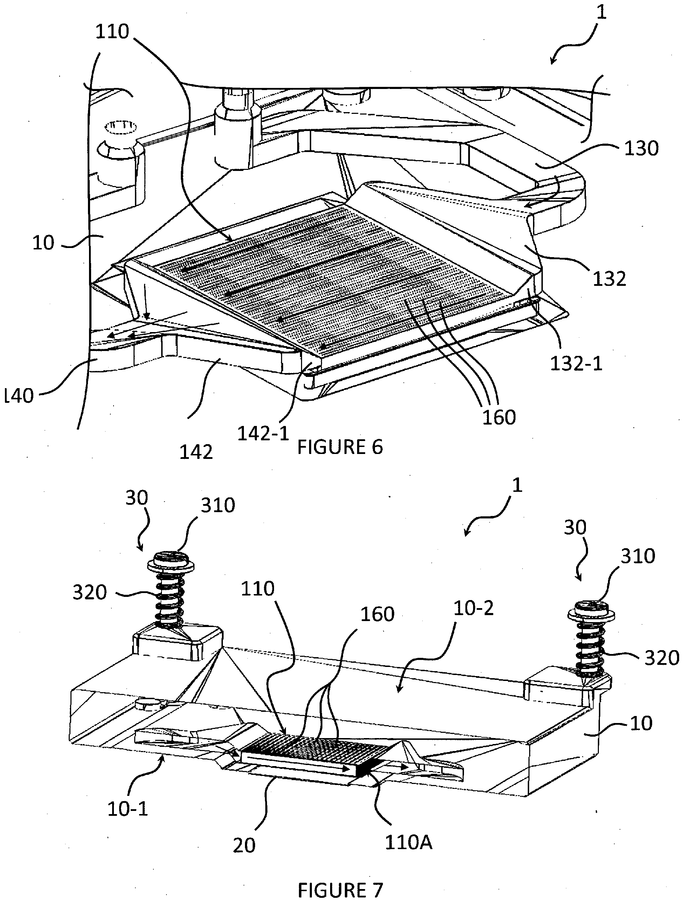

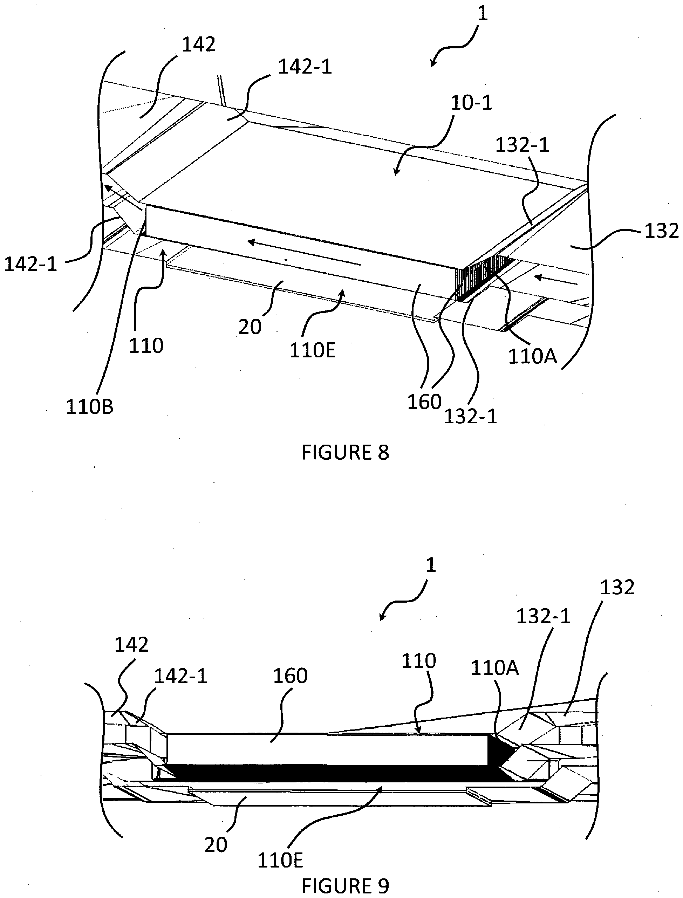

As illustrated on Figures 6, 8, 9, the cooling liquid injector 132 comprises an end portion 132-1 which is configured to guide the cooling liquid to leads through the first lateral face 110A of the internal cavity 110. In the example of the figures, in particular in reference to figures 8 and 9, the end portion 132-1 comprises walls to swerve the output of the cooling liquid injector 132 up to the first lateral face 110A and the fins 160. This allows to have the fins 160 lower than the cooling liquid injector 132 and closer to the thermal interface pad 20 to better collect the heat.

The end portion 132-1 may have a trapezoidal or frustoconical section where the liquid enters on a first side and is evacuated through a second side which is fluidically connected to the first lateral face 110A of the internal cavity 110. In a non-limiting manner, the first side has an area which is greater than the area of the second side to increase the pressure of the cooling liquid and force said cooling liquid to circulate between the fins 160.

The cooling liquid circulates between the fins 160 from the first lateral face 110A to a second lateral face 110B of the internal cavity 110 (figure 5), opposite to the first lateral face 110A.

The heated liquid channel 140 connects the internal cavity 110 to the heated liquid outlet 150 to evacuate the heated liquid from the internal cavity 110.

The heated liquid channel 140 comprises a heated liquid collector 142 (figures 5 and 6) connected on the width of the second lateral face 110B of the internal cavity 110 to allow the heated liquid to be collected from all the spaces between the fins 160 at the same time.

In reference to Figure 6, 8 and 9, the heated liquid collector 142 comprises an end portion 142-1 which is configured to collect the cooling liquid from the second lateral face 110B of the internal cavity 110. In the example of the figures, in particular in reference to figures 8 and 9, the end portion 142-1 comprises walls to swerve the input of the heated liquid collector 142 from the second lateral face 110B and the fins 160 and collect the heated liquid.

The end portion 142-1 may have a trapezoidal or frustoconical section where the liquid enters on a first side and is evacuated through a second side which is fluidically connected to the second lateral face 110B of the internal cavity 110. In a non-limiting manner, the first side has an area which is smaller than the area of the second side to decrease the pressure of the heated liquid to collect the heated liquid and circulate said heated liquid toward the heated liquid outlet 150.

The heated liquid outlet 150 is configured to evacuate the heated liquid outside the liquid cooling heatsink 1.

In the example of the figures, the cooling liquid inlet 120 and the heated liquid outlet 150 are arranged side-by-side on a lateral side of the body 10 and are connected on a guiding block 125 to ease the injection and the extraction of liquid respectively inside and outside the liquid cooling heatsink 1.

In reference to Figures 5, 6 and 10, the parallel fins 160 extend orthogonally to the thermal interface pad 20 and along a direction extending between the first lateral face 110A and the second lateral face 110B of the internal cavity 110.

Preferably, the width of each fin 160 is equal or smaller than 0.2 mm.

Preferably, the gap between two adjacent fins 160 is equal or smaller than 0.2 mm.

Preferably, the liquid cooling heatsink 1 comprises several dozens of fins 160, for example more than fifty, preferably more than eighty, e.g., eighty-eight fins 160.

In a non-limiting manner, as shown on Figures 8 and 9, an empty space 110E extends under the fins 160, between the fins 160 and the heat face 10-1 above the thermal interface pad 20, to increase the efficiency of the heat transfer and collection between said thermal interface pad 20 and said fins 160.

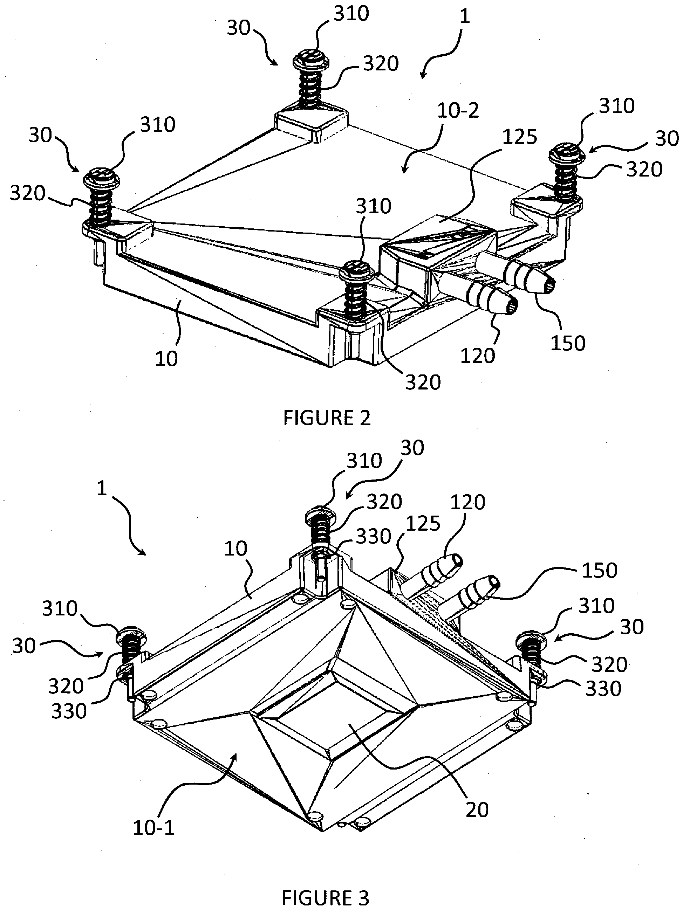

The liquid cooling heatsink 1 comprising fixation organs 30 configured to fix the body in the computing device 2. In a non-limiting manner, as shown for example on Figure 2, each fixation organ 30 comprises a screw 310 passing through a corresponding hole 170 of the body 10 (figures 4 and 5). A spring 320 is mounted on each screw 310 which is maintained in the corresponding hole 170 by a circlip 330. Such assembly allows to apply the right amount of pressure on the processor 3 surface. This helps to compress the thermal interface pad 20 effectively and reduce the thermal resistance.

In use, in reference to figure 11, a cooling liquid is sent through the liquid cooling inlet 120 and the liquid cooling channel 130 up to the internal cavity 110 in a step S1.

The heat generated by the microprocessor 3 is transferred through the thermal interface pad 20, the heat face 10-1 up to the plurality of fins 160 in a step S2.

The transferred heat is collected by the cooling liquid flowing between the fins 160 in a step S3 to produce a heated liquid that is evacuated through the heated liquid channel 140 and the heated liquid outlet 150 outside the liquid cooling heatsink 1 in a step S4.

The Specification, which includes the Summary of Invention, Brief Description of the Drawings and the Detailed Description of the Preferred Embodiments, and the appended Claims refer to particular features (including process or method steps) of the invention. Those of skill in the art understand that the invention includes all possible combinations and uses of particular features described in the Specification. Those of skill in the art understand that the invention is not limited to or by the description of embodiments given in the Specification but defined by the claims.

## Claims

1. A liquid cooling heatsink (1) for cooling a microprocessor (3) mounted on a printed circuit board (4) of a computing device (2), said liquid cooling heatsink (1) comprising a body (10) and a thermal interface pad (20), said body (10) comprising:
- a heat face (10-1),
- a mounting face (10-2), opposite said heat face (10-1),
- a parallelepipedal internal cavity (110) delimited inside the body (10) between the heat face (10-1) and the mounting face (10-2), the thermal interface pad (20) being mounted on the heat face (10-1) under said internal cavity (110) and being configured to contact said microprocessor (3) to collect the heat generated by said microprocessor (3) and transfer said collected heat through the body (10) up to the internal cavity (110),
- a cooling liquid inlet (120) configured to receive a cooling liquid,
- a cooling liquid channel (130) connecting said cooling liquid inlet (120) and said internal cavity (110) and comprising a cooling liquid injector (132) having an end portion (132-1) leading into the internal cavity (110) on the width of a first lateral face (110A) of said parallelepipedal internal cavity (110),
- a heated liquid channel (140) connected to said internal cavity (110) and comprising at one end a cooling liquid collector (142) having an end portion (142-1) spreading on the width of a second lateral face (110B) of the parallelepipedal internal cavity (110), opposite to the first lateral face (110A), and configured to evacuate the heated liquid,
- a heated liquid outlet (150) connected to the other end of the cooling liquid collector (142), the body (10) further comprising a plurality of parallel fins (160) mounted in the parallelepipedal internal cavity (110) orthogonally to said thermal interface pad (20) and along a direction extending between the first lateral face (110A) and the second lateral face (110B) of the parallelepipedal internal cavity (110) to allow the cooling liquid to flow between said fins (160).

2. The liquid cooling heatsink (1) according to claim 1, wherein the thickness of the thermal interface pad (20) is smaller than 1 mm, preferably equal or smaller than 0.2 mm.

3. The liquid cooling heatsink (1) according to any of the preceding claims, wherein the height of the parallelepipedal internal cavity (110) is smaller than 3 mm, preferably equal or smaller than 2.9 mm.

4. The liquid cooling heatsink (1) according to any of the preceding claims, wherein the width of each fin (160) is equal or smaller than 0.2 mm.

5. The liquid cooling heatsink (1) according to any of the preceding claims, wherein the gap between two adjacent fins (160) is equal or smaller than 0.2 mm.

6. The liquid cooling heatsink (1) according to any of the preceding claims, wherein the number of fins (160) is equal to or greater than fifty, preferably eighty.

7. The liquid cooling heatsink (1) according to any of the preceding claims, wherein the body (10) is made of aluminum 6063.

8. The liquid cooling heatsink (1) according to any of the preceding claims, wherein the thermal interface pad (20) is a phase change thermal pad or a phase change thermal paste.

9. The liquid cooling heatsink (1) according to the preceding claim, wherein the thermal interface pad (20) has a thermal impedance of 0.08 to 0.10 (°C cm²/w) when loaded with mounting pressure close to 40 psi (+ or - 10%).

10. The liquid cooling heatsink (1) according to any of the preceding claims, comprising fixation organs (30) configured to fix the body (10) inside the computing device (2).

11. The liquid cooling heatsink (1) according to the preceding claim, wherein the fixation organs (30) comprise screws (310).

12. The liquid cooling heatsink (1) according to any of claims 10 or 11, wherein the fixation organs (30) comprise springs (320) and circlips (330).

13. The liquid cooling heatsink (1) according to any of the preceding claims, wherein the cooling liquid inlet (120) and the heated liquid outlet (150) are arranged side-by-side.

14. A computing device (2) comprising a printed circuit board (4) and a liquid cooling heatsink (1) according to any of the preceding claims, said printed circuit board (4) comprising a microprocessor (3), wherein the thermal interface pad (20) of the liquid cooling heatsink (1) contacts the microprocessor (3).

15. A method for cooling a microprocessor (3) using a liquid cooling heatsink (1) according to any of the preceding claims, mounted on said microprocessor (3), said method comprising the steps of circulating (S1) a cooling liquid through the liquid cooling inlet (120) and the liquid cooling channel (130), transferring (S2) the heat generated by the microprocessor (3) through the thermal interface pad (20) and the plurality of fins (160), collecting (S3) the transferred heat by the cooling liquid flowing between the fins (160) of the plurality of fins (160) to produce a heated liquid, evacuating (S4) said heated liquid through the heated liquid channel (140) and the heated liquid outlet (150).
